# EUROPEAN PATENT APPLICATION

(11) **EP 4 503 122 A1**
(43) Date of publication of application: **05.02.2025**
(21) Application number: 23781360.5
(22) Date of filing: 29.03.2023
(51) Int. Cl.: H01L 23/498, H01L 23/14, H01L 23/00

(54) **CIRCUIT BOARD**

(30) Priority: 30.03.2022 KR 20220039306
(71) Applicant: LG INNOTEK CO. LTD, Gangseo-gu Seoul 07796 (KR)
(72) Inventor: KIM, Han Sang, Seoul 07796 (KR); PARK, Jae Man, Seoul 07796 (KR); YOU, Chae Young, Seoul 07796 (KR)
(74) Representative: Plasseraud IP
(86) International application number: PCT/KR2023/004197
(87) International publication number: WO 2023/191507

(57) **Abstract**

A circuit board according to an embodiment includes a first insulating layer; and a circuit layer disposed on the first insulating layer, wherein the circuit layer includes: a first layer disposed on the first insulating layer, and a second layer partially disposed on a surface of the first layer, wherein a profile of the surface of the first layer is different from a profile of a surface of the second layer.

## Description

### [Technical Field]

The embodiment relates to a circuit board and a semiconductor package including the same.

### [Background Art]

A circuit board is formed by forming a pattern of a circuit line on an electrically insulating substrate with a conductive material such as copper. A circuit board refers to a substrate before mounting an electronic component.

In other words, the circuit board may mean that a mounting position of each component is determined to mount various types of electronic components on a flat plate, and a circuit layer connecting the electronic components is formed.

Meanwhile, signal transmission in the circuit board may be performed through the circuit layer. For example, a semiconductor package has a structure in which an electronic component is mounted on a circuit board. In addition, signal transmission in the semiconductor package is performed through a circuit layer formed on the circuit board. In this case, a signal may include a signal input to an electronic component, a signal output from the electronic component, a signal input from an external substrate, and a signal output to an external substrate, etc.

On the other hand, in order to process a large amount of information at high speed with the high functionalization of portable electronic devices, etc., and the signal is becoming high frequency. In addition, there is a demand for a circuit board suitable for high frequency applications.

A circuit layer of such a circuit board must be capable of transmitting signals without deteriorating a quality of high-frequency signals. For example, the circuit layer of the circuit board should be able to minimize signal transmission loss.

At this time, the transmission loss of the circuit layer in the circuit board is mainly made up of conductor losses caused by metal thin layers such as copper and dielectric losses caused by insulators such as insulating layers.

The conductor losses due to the metal thin film is related to a surface roughness of the circuit layer. That is, as the surface roughness of the circuit layer increases, the transmission loss may increase due to a skin effect.

In addition, if the surface roughness of the circuit layer is reduced, signal transmission loss may be reduced. However, if the surface roughness of the circuit layer decreases, there is a problem that an adhesion between the circuit layer and the insulating layer decreases accordingly.

Therefore, there is a need for a new circuit board capable of improving the adhesion between the circuit layer and the insulating layer while minimizing signal transmission loss.

### [Disclosure]

### [Technical Problem]

An embodiment provides a circuit board capable of minimizing signal transmission loss and a semiconductor package including the same.

In addition, an embodiment provides a circuit board capable of improving an adhesion between a circuit layer and an insulating layer and a semiconductor package including the same.

In addition, an embodiment provides a circuit board suitable for high frequency applications and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises a first insulating layer; and a circuit layer disposed on the first insulating layer, wherein the circuit layer includes: a first layer disposed on the first insulating layer, and a second layer partially disposed on a surface of the first layer, wherein a profile of the surface of the first layer is different from a profile of a surface of the second layer.

In addition, the first layer of the circuit layer includes: a first metal layer disposed on an upper surface of the first insulating layer, and a second metal layer disposed on an upper surface of the first metal layer, wherein the second layer of the circuit layer includes a third metal layer disposed on an upper surface of the second metal layer, and a profile of the upper surface of the second metal layer is different from a profile of an upper surface of the third metal layer.

In addition, the upper surface of the second metal layer includes a plurality of mountains and a plurality of valleys, and wherein the third metal layer is formed on the upper surface of the second metal layer to fill at least a portion of the plurality of valleys.

In addition, the third metal layer is disposed on a side surface of the first metal layer and a side surface of the second metal layer, and wherein each profile of the side surface of the first metal layer and the side surface of the second metal layer is different from a profile of a side surface of the third metal layer.

In addition, each of the side surface of the first metal layer and the side surface of the second metal layer includes a plurality of mountains and a plurality of valleys, and wherein the third metal layer fills at least a portion of the plurality of valleys of each of the side surfaces of the first and second metal layers.

In addition, an upper surface of the circuit layer includes: a first portion corresponding to the upper surface of the second metal layer, and a second portion corresponding to the upper surface of the third metal layer.

In addition, an arithmetic average roughness Ra of the upper surface of the circuit layer has a range of 0.05 µm to 0.2 µm, and wherein a ten-point average roughness Rz of the upper surface of the circuit layer is in a range of 0.1 µm to 1.0 µm.

In addition, a side surface of the circuit layer includes: a first portion corresponding to the side surfaces of the first and second metal layers, and a second portion corresponding to a side surface of the third metal layer.

In addition, an arithmetic average roughness Ra of the side surface of the circuit layer has a range of 0.05 µm to 0.2 µm, and wherein a ten-point average roughness Rz of the side surface of the circuit layer is in a range of 0.1 µm to 1.0 µm.

In addition, the circuit board further comprises a second insulating layer disposed on the first insulating layer to cover the circuit layer, wherein a lower surface of the second insulating layer includes: a first lower surface in contact with the first layer of the circuit layer, a second lower surface in contact with the second layer of the circuit layer, and a third lower surface in contact with the first insulating layer.

In addition, the first layer of the circuit layer includes a first metal material, and the second layer of the circuit layer includes a second metal material different from the first metal material.

In addition, the first metal material contains copper, and the second metal material contains tin.

In addition, the first metal layer includes a first-first metal layer and a first-second metal layer disposed on the first-first metal layer, and the second metal layer is disposed on the first-second metal layer.

Meanwhile, a circuit board according to an embodiment comprises an insulating layer; and a circuit layer disposed on the insulating layer; wherein a surface of the circuit layer includes a first portion including a first metal material; and a second portion including a second metal material different from the first metal material, wherein the first metal material includes copper, and the second metal material includes tin.

In addition, the surface of the circuit layer includes an upper surface, a left side surface, a right side surface and a lower surface, and wherein an arithmetic average roughness Ra of at least two of the upper surface, the left side surface, the right side surface and the lower surface of the circuit layer has a range of 0.05 µm to 0.2 µm.

In addition, the surface of the circuit layer includes an upper surface, a left side surface, a right side surface and a lower surface, and wherein a ten-point average roughness Rz of at least two of at least two of the upper surface, the left side surface, the right side surface and the lower surface of the circuit layer has a range of 0.1 µm to 1.0 µm.

Meanwhile, a semiconductor package according to an embodiment includes a plurality of insulating layers, a plurality of circuit layers respectively disposed on surfaces of the plurality of insulating layers, a first connection part disposed on an uppermost circuit layer, a device disposed on the first connection part, and at least one first circuit layer among the plurality of circuit layers includes a first metal layer, a second metal layer disposed on the first metal layer, a third metal layer disposed on the first metal layer and the second metal layer, and an upper surface of the first circuit layer includes a first upper surface corresponding to the second metal layer and a second upper surface corresponding to the third metal layer, and a side surface of the first circuit layer includes a first side surface corresponding to the first metal layer and the second metal layer and a second side surface corresponding to the third metal layer, and at least one of the upper surface of the first circuit layer and the side surface of the first circuit layer has an arithmetic average roughness Ra in a range of 0.05 µm to 0.2 µm and a ten-point average roughness Rz in a range of 0.1 µm to 1.0 µm.

### [Advantageous Effects]

A circuit board according to an embodiment includes a circuit layer. The circuit layer includes a first metal layer corresponding to a seed layer and a second metal layer disposed on the first metal layer. In this case, a surface of the circuit layer can be provided with a certain level of surface roughness in a process of etching process the first metal layer. In addition, the surface roughness may act as a factor of increasing signal transmission loss. Accordingly, it may be difficult to apply to high frequency applications.

Accordingly, the circuit layer of the embodiment includes a third metal layer. The third metal layer is selectively disposed on a surface of the first metal layer and a surface of the second metal layer. For example, a surface of the circuit layer includes a first surface corresponding to an upper surface of the second metal layer. In addition, the third metal layer is partially disposed on the first surface. Specifically, the first surface includes a plurality of valleys and mountains corresponding to the surface roughness. In addition, the third metal layer is formed to fill a portion of the valleys on the first surface by controlling crystal grains of metal ions in a plating solution. Accordingly, the embodiment can reduce the surface roughness of the first surface based on a thickness of the third metal layer.

Correspondingly, the surface of the circuit layer includes a second surface corresponding to a first side surface of the first metal layer and a first side surface of the second metal layer. In addition, the surface of the circuit layer includes a third surface corresponding to a second side surface of the first metal layer and a second side surface of the second metal layer. In addition, the third metal layer is disposed to fill not only the first surface, but also a portion of the valley of the second surface and a portion of the valley of the third surface. Accordingly, an embodiment can reduce the surface roughness of the second surface and the third surface of the circuit layer.

Accordingly, the embodiment can reduce the signal transmission loss of the circuit layer compared to a comparative example. Accordingly, the embodiment can improve signal characteristics of the circuit board. Furthermore, the embodiment can provide a circuit board suitable for high frequency applications.

Meanwhile, the embodiment allows the third metal layer to be disposed so as to fill only a portion of the valleys of the first to third surfaces. Accordingly, embodiment may reduce the surface roughness of the circuit layer without affecting a thickness and a line width of the circuit layer including the first metal layer and the second metal layer. Accordingly, the embodiment may further improve electrical reliability and physical reliability of the circuit board.

Meanwhile, in an embodiment, an additional insulating layer is stacked on the circuit layer. In this case, the additional insulating layer additionally contacts the third metal layer as well as the first and second metal layers of the circuit layer. In this case, the first and second metal layers may include copper, and the third metal layers may include tin. In this case, the tin includes more hydroxyl groups than the copper. In addition, the additional insulating layer may have a higher adhesive force to the third metal layer than to the first and second metal layers. At this time, the additional insulating layer in the comparative example contacts only the first and second metal layers of the circuit layer. Accordingly, in the comparative example, there is a limit to increasing the adhesive force between the circuit layer and the additional insulating layer. Unlike this, the additional insulating layer of the embodiment additionally contacts the third metal layer as well as the first and second metal layers of the circuit layer. Accordingly, the embodiment may improve the adhesive force between the circuit layer and the additional insulating layer compared to the comparative example. Accordingly, the embodiment may further improve product reliability of the circuit board.

Meanwhile, an undercut is formed at a lower portion of a side surface of the circuit layer of the comparative example. In addition, the undercut acts as a factor for deteriorating the reliability of the circuit layer. In this case, the embodiment can reduce a depth of the undercut by a thickness of the third metal layer compared to the comparative example. Accordingly, the embodiment can further improve the product reliability of the circuit board.

### [Description of Drawings]

FIG. 1 is a cross-sectional view of a circuit board according to a comparative example.
FIG. 2 is a view showing a circuit board according to an embodiment.
FIG. 3 is a view for explaining a layer structure of a circuit layer according to a first embodiment.
FIG. 4 is a view for explaining a layer structure of a circuit layer according to a second embodiment.
FIG. 5 is a view showing a circuit layer according to a first embodiment.
FIG. 6 is a view showing a surface of a circuit layer before a surface treatment process according to the embodiment is performed.
FIG. 7 is a view showing a surface of a circuit layer after a surface treatment process according to the embodiment is performed.
FIG. 8 is a view showing a circuit layer according to a second embodiment.
FIG. 9 is a view for explaining an adhesive force between a circuit layer and an insulating layer according to the embodiment.
FIG. 10 is a view showing an undercut of a circuit layer according to a comparative example.
FIG. 11 is a view showing an undercut of a circuit layer according to an embodiment.
FIG. 12 is a view showing a semiconductor package according to an embodiment.
FIGS. 13 to 23 are views for explaining a method for manufacturing a circuit board according to an embodiment in order of process.

### [Modes of the Invention]

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms may be construed the same meaning as commonly understood by one of ordinary skill in the art to which this invention belongs, and the terms such as those defined in commonly used dictionaries may be interpreted as having a meaning that is consistent with their meaning in the context of the relevant art.

Further, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

Before describing the embodiment, a circuit board of a comparative example will be described.

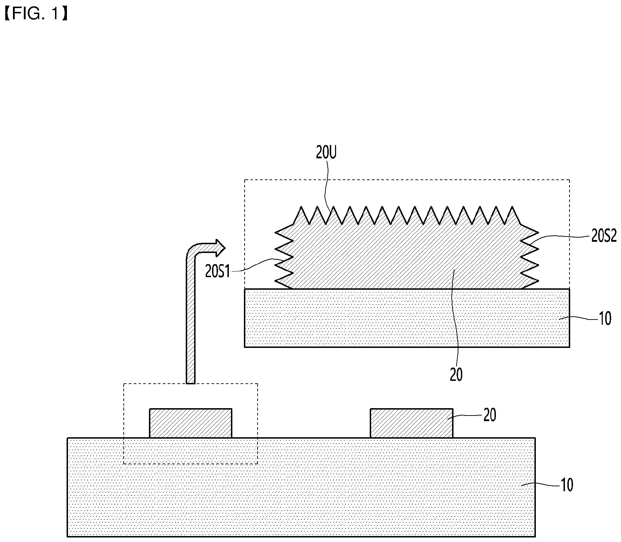

FIG. 1 is a cross-sectional view of a circuit board according to a comparative example.

Referring to FIG. 1, the circuit board of the comparative example includes an insulating layer 10 and a circuit layer 20.

The circuit layer 20 is disposed on a surface of the insulating layer 10. For example, the circuit layer 20 is disposed on at least one of an upper surface and a lower surface of the insulating layer 10.

The circuit layer 20 includes a plurality of surfaces.

For example, the circuit layer 20 includes a first surface 20U, a second surface 20S1, and a third surface 20S2. The first surface 20U may mean an upper surface of the circuit layer 20. The second surface 20S1 may mean a first side surface or a left side surface of the circuit layer 20. The third surface 20S2 may mean a second side surface or a right side surface of the circuit layer 20. Also, the circuit layer 20 may include a fourth surface or a lower surface contacting an upper surface of the insulating layer 10.

In this case, the first surface 20U, the second surface 20S1, and the third surface 20S2 of the circuit layer 20 have specific surface roughness.

The surface roughness may be applied during a manufacturing process of forming the circuit layer 20. For example, the circuit layer 20 has a plurality of layer structures. For example, the circuit layer 20 includes a first metal layer (not shown) and a second metal layer (not shown). The first metal layer may mean a seed layer for electroplating the second metal layer. In addition, the second metal layer may be an electroplating layer formed by electroplating the first metal layer with a seed layer.

In addition, the circuit layer 20 of the circuit board of the comparative example may be manufactured by forming the second metal layer on the first metal layer and etching a region that does not overlap the second metal layer in a thickness direction among an entire region of the first metal layer.

In this case, a specific surface roughness may be applied to the first surface 20U, the second surface 20S1, and the third surface 20S2 of the circuit layer 20 in a process of etching the first metal layer.

For example, an arithmetic average roughness Ra of the first surface 20U, the second surface 20S1, and the third surface 20S2 of the circuit layer 20 of the comparative example exceeds 0.3 µm. For example, a ten-point average roughness Rz of the first surface 20U, the second surface 20S1, and the third surface 20S2 of the circuit layer 20 of the comparative example exceeds 3.5 µm.

Accordingly, the circuit layer 20 of the comparative example has a problem in that the signal transmission loss is relatively high due to the arithmetic average roughness and the ten-point average roughness of the first surface 20U, the second surface 20S1, and the third surface 20S2. For example, the signal transmission loss increases in proportion to the surface roughness of the circuit layer 20. In addition, the circuit board of the comparative example has a problem in that the signal transmission loss is relatively high due to a skin effect due to the arithmetic average roughness or the ten-point average roughness of the first surface 20U, the second surface 20S1, and the third surface 20S2 of the circuit layer 20. Therefore, the circuit board of the comparative example has a problem in that it is difficult to apply to high frequency applications.

In addition, in the comparative example, the surface roughness of the circuit layer 20 is reduced by oxidizing a surface of the circuit layer 20.

For example, in the comparative example, an oxide layer is formed by oxidizing the surface of the circuit layer 20, and a surface roughness of the circuit layer 20 decreases by reducing the oxide layer. However, the adhesive force between the formed oxide layer and the circuit layer 20 is relatively low. Accordingly, in a process of forming the oxide layer, a portion of the oxide layer may be separated from the circuit layer 20. In addition, if the oxide layer is separated from the circuit layer 20, there is a problem that the surface roughness of a corresponding portion is relatively high. In addition, in the process of reducing the oxide layer, there may be a problem that the oxide layer cannot be partially reduced. In addition, if the oxide layer is not partially reduced, there may be a problem that the electrical reliability of the circuit layer 20 is deteriorated.

Meanwhile, if the surface roughness of the circuit layer 20 is recklessly reduced, another problem may occur. For example, a circuit board is manufactured by performing a process of stacking a plurality of insulating layers. In this case, if the surface roughness of the circuit layer 20 decreases, there is a problem that an adhesive force between the circuit layer 20 and the insulating layer (not shown) which is additionally stacked is deteriorated. Accordingly, there may be a problem that the additionally stacked insulating layer is separated from the circuit layer 20.

Accordingly, an embodiment provides a circuit board having a new structure capable of improving an adhesive force between the circuit layer and an insulating layer while lowering the surface roughness of the circuit layer compared to the comparative example, and a semiconductor package including the same. Accordingly, an embodiment provides a circuit board and a semiconductor package suitable for high frequency applications.

### -Electronic device-

Before describing an embodiment, an electronic device including the semiconductor package of the embodiment will be briefly described. The electronic device includes a main board (not shown). The main board may be physically and/or electrically connected to various components. For example, the main board may be electrically connected to the semiconductor package of the embodiment. Various devices may be mounted on the semiconductor package.

Memory chips such as volatile memory (e.g., DRAM), non-volatile memory (e.g., ROM), and flash memory, application processor chips such as a central processor (e.g., CPU), graphics processor (e.g., GPU), antenna chip, digital signal processor, cryptographic processor, microprocessor, and microcontroller, and logic chips such as analog-digital converters and ASICs (application-specific ICs) can be mounted in the semiconductor package.

For example, at least one of various types of passive devices and active devices may be mounted in the semiconductor package.

In this case, the electronic device may be a smart phone, a personal digital assistant, a digital video camera, a digital still camera, a vehicle, a highperformance server, a network system, computer, monitor, tablet, laptop, netbook, television, video game, smart watch, automotive, or the like. However, the embodiment is not limited thereto, and may be any other electronic device that processes data in addition to these.

Hereinafter, a circuit board and a semiconductor package according to an embodiment will be described in detail. Here, the circuit board may refer to a substrate before an electronic device is mounted. In addition, the semiconductor package may refer to a package in which an electronic device is mounted on the circuit board.

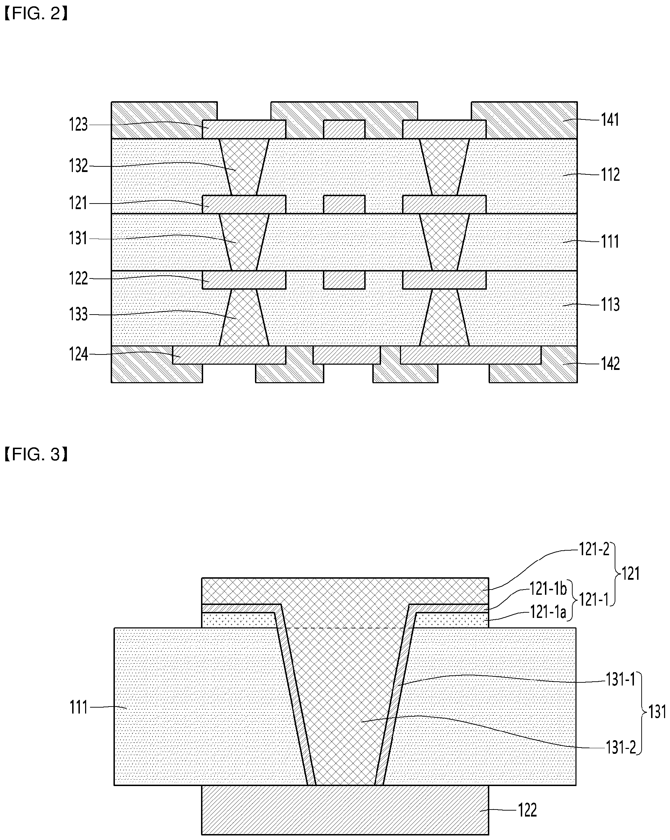

FIG. 2 is a view showing a circuit board according to an embodiment.

Referring to FIG. 2, the circuit board may include an insulating layer, a circuit layer, a through electrode, and a protective layer. In this case, although the circuit board is illustrated to have a three-layer structure based on a number of layers of the insulating layer in the drawing, the embodiment is not limited thereto. For example, the circuit board may have two or less layers based on a number of layers of the insulating layer, or may have four or more layers.

The insulating layer may include a first insulating layer 111, a second insulating layer 112, and a third insulating layer 113. The first insulating layer 111 may mean an insulating layer disposed inside a stacked structure of a circuit board. In addition, the second insulating layer 112 may mean an insulating layer disposed on the first insulating layer 111. In addition, the third insulating layer 113 may mean an insulating layer disposed below the first insulating layer 111.

At least one of the first insulating layer 111 and the third insulating layer 112 and the third insulating layer 113 may include a prepreg (PPG). The prepreg may be formed by impregnating a fiber layer in the form of a fabric sheet, such as a glass fabric woven with glass yarn, with an epoxy resin, and then performing thermocompression. However, the embodiment is not limited to this, and the prepreg constituting At least one of the first insulating layer 111 and the third insulating layer 112 and the third insulating layer 113 may include a fiber layer in the form of a fabric sheet woven with carbon fiber yarn.

For example, at least one of the first insulating layer 111, the second insulating layer 112, and the third insulating layer 113 may be rigid or flexible.

At least one of the first insulating layer 111, the second insulating layer 112, and the third insulating layer 113 may have a thickness in a range of 10 µm to 60 µm. Preferably, at least one of the first insulating layer 111, the second insulating layer 112, and the third insulating layer 113 may have a thickness in a range of 12 µm to 50 µm. More preferably, at least one of the first insulating layer 111, the second insulating layer 112, and the third insulating layer 113 may have a thickness in a range of 15 µm to 40 µm.

If the thickness of at least one of the first insulating layer 111, the second insulating layer 112, and the third insulating layer 113 is less than 10 µm, the circuit layer included in an antenna substrate may not be stably protected. If the thickness of at least one of the first insulating layer 111, the second insulating layer 112, and the third insulating layer 113 is greater than 60 µm, the thickness of the circuit board, the semiconductor package, and the electronic device including the same may increase. Also, If the thickness of at least one of the first insulating layer 111, the second insulating layer 112, and the third insulating layer 113 is greater than 60 µm, a thickness of the circuit layer and a thickness of the through electrode may increase correspondingly. In addition, if a thickness of the circuit layer and a thickness of the through electrode increase, the signal transmission loss may increase.

A circuit layer may be disposed on a surface of the insulating layer.

The circuit layer may be disposed on the surface of the insulating layer to transmit a signal in the circuit board.

For example, the circuit layer may be disposed on each surface of the first insulating layer 111, the second insulating layer 112, and the third insulating layer 113.

Specifically, the circuit layer may include a first circuit layer 121 disposed on an upper surface of the first insulating layer 111. Also, the circuit layer may include a first circuit layer 121 disposed on a lower surface of the first insulating layer 111. Also, the circuit layer may include a third circuit layer 123 disposed on an upper surface of the second insulating layer 112. Also, the circuit layer may include a fourth circuit layer 124 disposed on a lower surface of the third insulating layer 113.

Each of the first circuit layer 121, the second circuit layer 122, the third circuit layer 123, and the fourth circuit layer 124 may have a thickness of 10 µm to 25 µm. Preferably, each of the first circuit layer 121, the second circuit layer 122, the third circuit layer 123, and the fourth circuit layer 124 may have a thickness of 12 µm to 23 µm. More preferably, each of the first circuit layer 121, the second circuit layer 122, the third circuit layer 123, and the fourth circuit layer 124 may have a thickness of 15 µm to 20 µm.

The first circuit layer 121, the second circuit layer 122, the third circuit layer 123, and the fourth circuit layer 124 may include a conductive material. For example, the first circuit layer 121, the second circuit layer 122, the third circuit layer 123, and the fourth circuit layer 124 may include at least one metal material selected from gold (Au), silver (Ag), platinum (Pt), titanium (Ti), tin (Sn), copper (Cu), and zinc (Zn). Preferably, the first circuit layer 121, the second circuit layer 122, the third circuit layer 123, and the fourth circuit layer 124 may be formed of copper (Cu) having high electrical conductivity and relatively low cost.

On the other hand, the first circuit layer 121, the second circuit layer 122, the third circuit layer 123, and the fourth circuit layer 124 can be formed using the typical circuit board manufacturing process such as Additive Process, Subactive Process, MSAP (Modified Semi Additive Process), and SAP (Semi Additive Process), and detailed explanations are omitted here.

The circuit board includes a through electrode. For example, the circuit board includes a through electrode passing through the insulating layer and electrically connecting circuit layers disposed on different layers.

For example, the through electrode includes a first through electrode 131 passing through the first insulating layer 111. The first through electrode 131 may electrically connect the first circuit layer 121 and the second circuit layer 122.

In addition, the through electrode includes a second through electrode 132 passing through the second insulating layer 112. The second through electrode 132 may electrically connect the first circuit layer 121 and the third circuit layer 123.

In addition, the through electrode includes a third through electrode 133 passing through the third insulating layer 113. The third through electrode 133 may electrically connect the second circuit layer 122 and the fourth circuit layer 124.

In addition, the circuit board includes a protective layer. The protective layer may be disposed on an uppermost side or a lowermost side of the circuit board. The protective layer may protect a surface of a circuit layer or an insulating layer disposed on an uppermost side or a lowermost side of the circuit board.

Preferably, the protective layer may include a first protective layer 141 disposed on an upper surface of the second insulating layer 112. The first protective layer 141 may protect an upper surface of the second insulating layer 112 and an upper surface of the third circuit layer 123. In addition, the first protective layer 141 may include a first opening (not shown) overlapping at least a portion of an upper surface of the third circuit layer 123 in a thickness direction. The first opening may be formed to correspond to a mounting position of an electronic device.

In addition, the protective layer may include a second protective layer 142 disposed on a lower surface of the third insulating layer 113. The second protective layer 142 may protect a lower surface of the third insulating layer 113 and a lower surface of the fourth circuit layer 124. In addition, the second protective layer 142 may include a second opening (not shown) overlapping at least a portion of a lower surface of the fourth circuit layer 124 in a thickness direction. The second opening may be formed to correspond to a mounting position of an electronic device or a connection position with an external substrate.

In this case, the first protective layer 141 and the second protective layer 142 may be solder resist, but are not limited thereto.

Hereinafter, a layer structure of a circuit layer and a surface roughness thereof according to an embodiment will be described in detail.

In this case, the layer structure of the circuit layer may vary according to a method of manufacturing the circuit board. For example, the circuit layer may have different numbers of layers according to the method of manufacturing the circuit board.

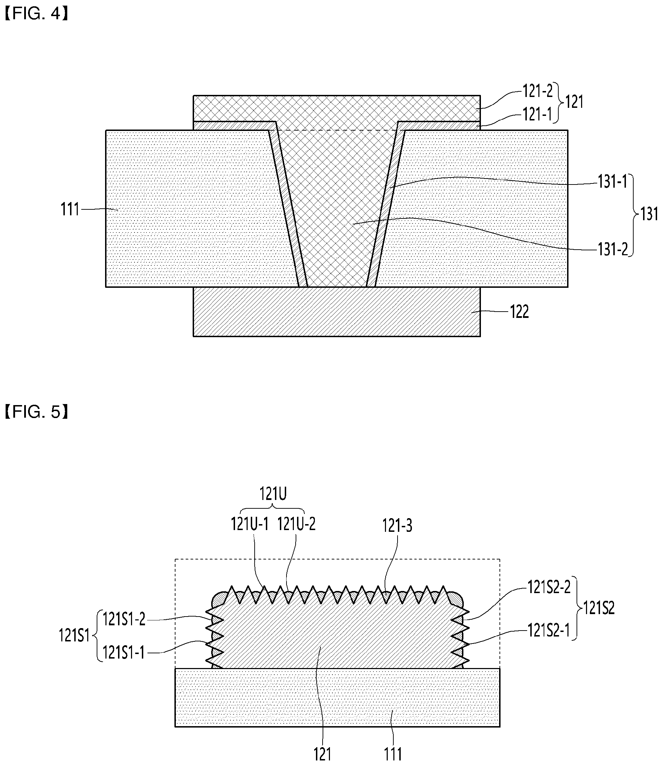

FIG. 3 is a view for explaining a layer structure of a circuit layer according to a first embodiment, and FIG. 4 is a view for explaining a layer structure of a circuit layer according to a second embodiment.

Hereinafter, any one of the first circuit layer 121 to the fourth circuit layer 124 will be mainly described. For example, hereinafter, a layer structure of the first circuit layer 121 will be described. However, a layer structure of the second circuit layer 122, the third circuit layer 123, and the fourth circuit layer 124 may correspond to a layer structure of the first circuit layer 121 described below.

Accordingly, hereinafter, the first insulating layer 111 will be referred to as an insulating layer, the first circuit layer 121 will be referred to as a circuit layer, and the first through electrode 131 will be referred to as a through electrode.

Referring to FIG. 3, the circuit board of the first embodiment may be manufactured by the MSAP method.

Meanwhile, hereinafter, it has been described that the circuit layer includes first to third metal layers.

In this case, the circuit layer may include a first layer and a second layer.

In addition, the first layer of the circuit layer may mean a first metal layer and a second metal layer to be described below. In addition, the second layer of the circuit layer may mean a third metal layer to be described below.

Hereinafter, the first to third metal layers of the circuit layer will be mainly described.

Meanwhile, the circuit board includes an insulating layer 111, a circuit layer 121, and a through electrode 131.

The circuit layer 121 may include a first metal layer 121-1 and a second metal layer 121-2.

The first metal layer 121-1 of the circuit layer 121 may be disposed on an upper surface of the insulating layer 111. The first metal layer 121-1 of the circuit layer 121 may mean a seed layer of the circuit layer 121.

In this case, the circuit layer 121 is manufactured by an MSAP process. Accordingly, the first metal layer 121-1 of the circuit layer 121 may be formed of a plurality of layers.

Preferably, the first metal layer 121-1 of the circuit layer 121 may include a first-first metal layer 121-1a and a first-second metal layer 121-1b.

The first-first metal layer 121-1a of the first metal layer 121-1 of the circuit layer 121 may be disposed on an upper surface of the insulating layer 111. The first-first metal layer 121-1a of the first metal layer 121-1 of the circuit layer 121 may mean a copper foil layer disposed on the upper surface of the insulating layer 111. For example, the first-first metal layer 121-1a of the first metal layer 121-1 of the circuit layer 121 may mean a copper foil.

The first-second metal layer 121-1b of the first metal layer 121-1 of the circuit layer 121 may be disposed on the first-first metal layer 121-1a. For example, the first-second metal layer 121-1b of the first metal layer 121-1 of the circuit layer 121 may be formed on the first-first metal layer 121-1a by electroless plating. Preferably, the first-second metal layer 121-1b of the first metal layer 121-1 of the circuit layer 121 may be a chemical copper plating layer.

The second metal layer 121-2 of the circuit layer 121 is disposed on the first metal layer 121-1 of the circuit layer 121. For example, the second metal layer 121-2 of the circuit layer 121 is disposed on the first-second metal layer 121-1b of the first metal layer 121-1 of the circuit layer 121. For example, the second metal layer 121-2 of the circuit layer 121 may be an electroplating layer formed by electroplating the first-second metal layer 121-1b with a seed layer.

Meanwhile, the through electrode 131 may penetrate the insulating layer 111. For example, the through electrode 131 may be formed by filling an inside of the through hole penetrating the insulating layer 111 with a conductive material. In this case, the through electrode 131 may be formed simultaneously in a process of forming the circuit layer 121.

Preferably, the through electrode 131 includes a first metal layer 131-1 corresponding to the first metal layer 121-1 of the circuit layer 121. Preferably, the first metal layer 131-1 of the through electrode 131 may correspond to the first-second metal layer 121-1b of the first metal layer 121-1 of the circuit layer 121.

Specifically, the first-second metal layer 121-1b of the first metal layer 121-1 of the circuit layer 121 and the first metal layer 131-1 of the through electrode 131 may refer to one layer formed by a chemical copper plating process. However, the first-second metal layer 121-1b of the first metal layer 121-1 of the circuit layer 121 and the first metal layer 131-1 of the through electrode 131 may be classified according to an arrangement position of the chemical copper plating layer.

For example, in one chemical copper plating layer, the first-second metal layer 121-1b of the first metal layer 121-1 of the circuit layer 121 may refer to a portion of the circuit layer 121 in contact with the first-first metal layer 121-1a of the first metal layer 121-1.

For example, in one chemical copper plating layer, the first metal layer 131-1 of the through electrode 131 may refer to a portion in contact with an inner wall of a through hole penetrating the insulating layer 111.

Meanwhile, the through electrode 131 may include a second metal layer 131-2. The second metal layer 131-2 of the through electrode 131 may correspond to the second metal layer 121-2 of the circuit layer 121.

Preferably, the through electrode 131 includes a second metal layer 131-2 corresponding to the second metal layer 121-2 of the circuit layer 121. That is, the second metal layer 121-2 of the circuit layer 121 and the second metal layer 131-2 of the through electrode 131 may mean one layer formed by electroplating the chemical copper plating layer as a seed layer. However, the second metal layer 121-2 of the circuit layer 121 and the second metal layer 131-2 of the through electrode 131 may be classified according to an arrangement position of the electroplating layer.

For example, the second metal layer 131-2 of the through electrode 131 may refer to a portion of one electroplating layer disposed within the through hole of the insulating layer 111. For example, the second metal layer 121-2 of the circuit layer 121 may refer to a portion of one electroplating layer disposed outside the through hole.

Meanwhile, the circuit layer of the circuit board of the second embodiment shown in FIG. 4 may have a different number of layers from the circuit layer of the circuit board of the first embodiment shown in FIG. 3.

For example, the through electrode of the circuit board of the second embodiment may have substantially the same structure as the through electrode of the circuit board of the first embodiment.

However, the circuit layer 121 of the circuit board of the second embodiment may have a different number of layers from the circuit layer of the circuit board of the first embodiment.

For example, the circuit layer 121 of the circuit board of the second embodiment includes a first metal layer 121-1 and a second metal layer 121-2.

In this case, the first metal layer 121-1 of the circuit layer of the circuit board of the first embodiment includes a first-first metal layer 121-1a and a first-second metal layer 121-1b.

Alternatively, the first metal layer 121-1 of the circuit layer 121 of the circuit board of the second embodiment may be formed of a single layer. For example, the circuit layer 121 of the circuit board of the second embodiment may include only the first-second metal layer 121-1b in the first metal layer of the first embodiment.

That is, the circuit board of the second embodiment may be manufactured by a SAP method. And, in a process of forming the circuit layer by the SAP method, the copper foil layer or the copper foil corresponding to the first-first metal layer 121-1a disposed on a surface of the insulating layer may be removed. Accordingly, in the circuit board of the second embodiment, the first metal layer corresponding to the seed layer may include only the first-second metal layer 121-1b corresponding to the chemical copper plating layer. In addition, the first metal layer 121-1 corresponding to the first-second metal layer 121-1b of the second embodiment may be in direct contact with the upper surface of the insulating layer 111.

Meanwhile, the circuit layer 121 of the circuit board in FIGS. 3 and 4 may illustrate a circuit layer before a surface treatment process is performed according to an embodiment.

Hereinafter, a surface structure of the circuit layer 121 according to an embodiment will be described in detail. Specifically, the circuit layer 121 of an embodiment may be formed by performing a surface treatment on the circuit layer of FIGS. 3 and 4.

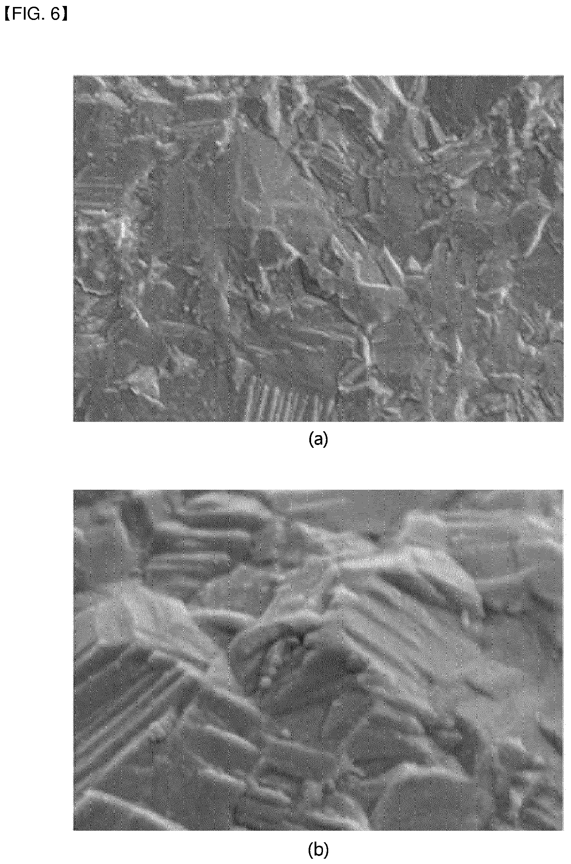

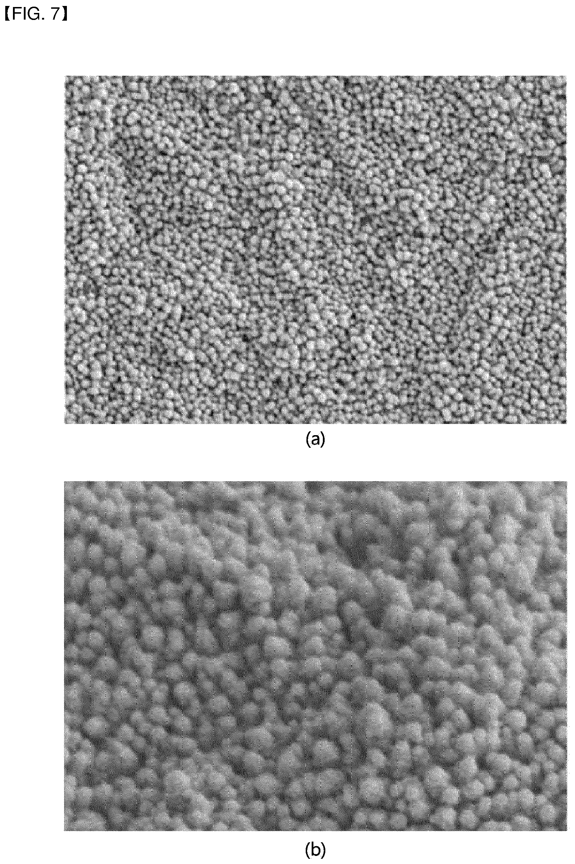

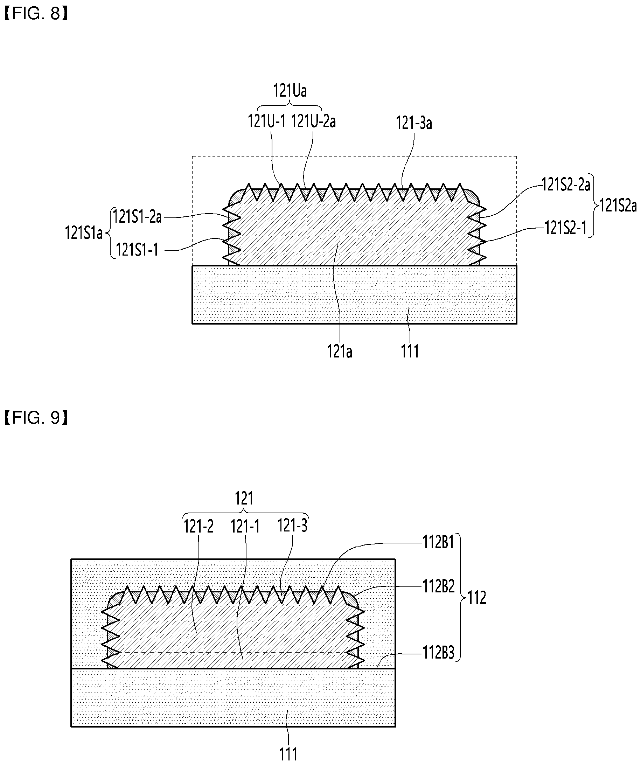

FIG. 5 is a view showing a circuit layer according to a first embodiment, FIG. 6 is a view showing a surface of a circuit layer before a surface treatment process according to the embodiment is performed, FIG. 7 is a view showing a surface of a circuit layer after a surface treatment process according to the embodiment is performed, and FIG. 8 is a view showing a circuit layer according to a second embodiment.

Referring to FIG. 5, a circuit layer 121 according to a first embodiment includes a surface. In this case, a surface of the circuit layer 121 may include a first surface 121U, a second surface 121S1, and a third surface 121S2.

In this case, the first surface 121U of the circuit layer 121 may mean an upper surface of the circuit layer 121. In addition, the second surface 121S1 of the circuit layer 121 may mean a first side surface or a left side surface of the circuit layer 121. In addition, the third surface 121S2 of the circuit layer 121 may mean a second side surface or a right side surface opposite to the first side surface of the circuit layer 121.

In detail, the first surface 121U of the circuit layer 121 may refer to an upper surface of the second metal layer 121-2 of the circuit layer 121. In addition, the second surface 121S1 of the circuit layer 121 may refer to a left side surface of the first metal layer 121-1 and a left side surface of the second metal layer 121-2. For example, the second surface 121S1 of the circuit layer 121 may include a first portion corresponding to a left side surface or a first side surface of the first metal layer 121-1, and a second portion corresponding to a left side surface or a first side surface of the second metal layer 121-2. In addition, the third surface 121S2 of the circuit layer 121 may refer to a right side surface of the first metal layer 121-1 and a right side surface of the second metal layer 121-2. For example, the third surface 121S2 of the circuit layer 121 may include a first portion corresponding to a right side surface or a second side surface of the first metal layer 121-1 of the circuit layer 121, and a second portion corresponding to a right side surface or a second side surface of the second metal layer 121-2.

In this case, the first surface 121U, the second surface 121S1, and the third surface 121S2 may mean a surface of the circuit layer 121 before the surface treatment described below is performed. Preferably, the first surface 121U, the second surface 121S1, and the third surface 121S2 may mean a surface consisting of the first metal layer 121-1 and the second metal layer 121-2 of the circuit layer 121.

In addition, surfaces of the circuit layer 121 that are finally formed further include not only the first metal layer 121-1 and the second metal layer 121-2, but also a third metal layer 121-3, corresponding to a surface layer described below. Accordingly, in the embodiment, surfaces of the circuit layer 121 that are finally formed may have a structure including the third surface 121S2.

Hereinafter, it will be described that the first surface 121U, the second surface 121S1, and the third surface 121S2 of the circuit layer 121 refer to a surface before a surface treatment process is performed. However, surfaces of the circuit layer 121 that are finally formed may have a structure including a third metal layer 121-3, which will be described below. This will be described in more detail below.

Meanwhile, the first surface 121U, the second surface 121S1, and the third surface 121S2 of the circuit layer 121 may have a predetermined surface roughness. For example, at least one of the first surface 121U, the second surface 121S1, and the third surface 121S2 of the circuit layer 121 may have a surface roughness corresponding to a surface roughness of the circuit layer 20 of the comparative example.

For example, an arithmetic average roughness Ra of the first surface 121U, the second surface 121S1, and the third surface 121S2 of the circuit layer 121 may exceed 0.3 µm. For example, a ten-point average roughness Rz of the first surface 121U, the second surface 121S1, and the third surface 121S2 of the circuit layer 121 may exceed 3.5 µm.

Meanwhile, the circuit board of an embodiment may include a surface layer 121-3 formed on at least one of the first surface 121U, the second surface 121S1, and the third surface 121S2 of the circuit layer 121. For example, the circuit board of an embodiment may include a surface layer 121-3 formed on at least two of the first surface 121U, the second surface 121S1, and the third surface 121S2 of the circuit layer 121.

Preferably, the surface layer 121-3 may be formed on each of the first surface 121U, the second surface 121S1, and the third surface 121U of the circuit layer 121. In this case, the surface layer 121-3 may also be referred to as a third metal layer of the circuit layer 121. Hereinafter, the surface layer 121-3 will be described as a third metal layer 121-3.

The third metal layer 121-3 may be formed on the first surface 121U, the second surface 121S1, and the third surface 121S2 of the circuit layer 121, respectively.

In this case, the third metal layer 121-3 may include a metal material different from those of the first metal layer 121-1 and the second metal layer 121-2 of the circuit layer 121. For example, the first metal layer 121-1 and the second metal layer 121-2 of the circuit layer 121 may include copper. In addition, the third metal layer 121-3 of the circuit layer 121 may include a metal material other than copper. For example, the third metal layer 121-3 of the circuit layer 121 may include tin (Sn).

Preferably, the circuit layer 121 of an embodiment may include a third metal layer 121-3 formed by electroless plating tin (Sn) on the first surface 121U, the second surface 121S1, and the third surface 121S2.

In this case, the third metal layer 121-3 may be partially formed on the first surface 121U, the second surface 121S1, and the third surface 121S2 of the circuit layer 121.

For example, a profile of the third metal layer 121-3 may be different from a profile of the first surface 121U, the second surface 121S1, and the third surface 121S2 of the circuit layer 121.

In detail, profiles of the first surface 121U, the second surface 121S1, and the third surface 121S2 of the circuit layer 121 may correspond to the arithmetic average roughness Ra and the ten-point average roughness Rz.

For example, the first surface 121U, the second surface 121S1, and the third surface 121S2 of the circuit layer 121 include a plurality of mountains and valleys corresponding to the arithmetic average roughness Ra and the ten-point average roughness Rz. The mountain may mean a portion of the first surface 121U, the second surface 121S1, and the third surface 121S2 of the circuit layer 121 that protrude outward from the circuit layer 121. In addition, the valley may mean a portion of the first surface 121U, the second surface 121S1, and the third surface 121S2 of the circuit layer 121 that is recessed inward from the circuit layer 121.

Profiles of the first surface 121U, the second surface 121S1, and the third surface 121S2 of the circuit layer 121 may include mountains and valleys corresponding to the arithmetic average roughness Ra and the ten-point average roughness Rz.

In addition, the third metal layer 121-3 of the circuit layer 121 may have a profile different from that of the first surface 121U, the second surface 121S1, and the third surface 121S2 of the circuit layer 121.

For example, in a case of a general electroless plating layer, a profile of the electroless plating layer above may correspond to a profile of an underlying layer.

Alternatively, the third metal layer 121-3 of an embodiment may have a profile different from a profile of the first surface 121U, the second surface 121S1, and the third surface 121S2 of the circuit layer 121 as an underlayer.

This may be achieved by a composition of a plating solution for forming the third metal layer 121-3. Hereinafter, the composition of the plating solution for forming the third metal layer 121-3 will be described first.

The plating solution includes tin (Sn). For example, the plating solution may include a first tin ion. For example, the plating solution may include a first tin salt. Specifically, the plating solution may contain at least one tin salt selected from a group consisting of tin methanesulfonate, tin sulfate, tin sulfamate, and tin pyrophosphate.

In addition, the plating solution may include a complexing agent. The complexing agent may be added to the plating solution to enable copper substitution plating, which is theoretically impossible to be plated by a surface electrode potential in electroless plating. For example, the complexing agent may include a thiourea derivative. Preferably, the complexing agent may be selected from the group consisting of 1,3 dimethylthiourea, trimethylthiourea and diethylthiourea.

In addition, the plating solution may include a stabilizer. The stabilizer may be added to the plating solution to stabilize or prevent decomposition of the tin plating solution. For example, the stabilizer may be selected from the group consisting of thiosulfate, sulfite, thioglycolic acid, and thioglycol polyethoxylate.

In addition, the plating solution may include an antioxidant. The antioxidant may be added to the plating solution to prevent oxidation of the first tin ion included in the plating solution to a second tin ion (e.g., tetravalent tin ion). For example, the antioxidant may be selected from the group consisting of resorcin, prologlucin, hydrazine, hypophosphorous acid, ascorbic acid, and cresol sulfonic acid.

In addition, the plating solution may include a surfactant. The surfactant may be added to the plating solution to improve appearance, density, smoothness, and adhesion of a plating film. For example, the surfactant may include ethylene oxide or propylene oxide.

In addition, the plating solution may include an additive. The additive may function to reduce the crystal grains of the tin ions by combining with tin ions included in the plating solution. For example, the additive may include benzotriazole or imidazole.

As described above, the additive for controlling the crystal grains of the tin ion is added to the plating solution of the embodiment. In addition, the additive may reduce the crystal grains of the tin ion, so that plating is performed so that the third metal layer 121-3 does not follow the profile of the first surface 121U, the second surface 121S1, and the third surface 121S2 of the circuit layer 121.

For example, the first surface 121U, the second surface 121S1, and the third surface 121S2 of the circuit layer 121 include valleys and mountains. In addition, the third metal layer 121-3 may be formed to fill valleys of the first surface 121U, the second surface 121S1, and the third surface 121S2 of the circuit layer 121 due to the additive. For example, the third metal layer 121-3 may be formed to fill a portion of valleys of the surface of the circuit layer 121. Accordingly, in an embodiment, surface roughness of the first surface 121U, the second surface 121S1, and the third surface 121S2 of the circuit layer 121 may be reduced based on a thickness of the third metal layer 121-3. In this case, the third metal layer 121-3 may have a thickness of about 0.1 µm and may fill valleys of the surface of the circuit layer 121.

Accordingly, in the embodiment, surfaces of the circuit layer 121 that are finally formed may include a first portion corresponding to the first and second metal layers 121-1 and 121-2, and a second portion corresponding to the third metal layer 121-3.

For example, the first surface 121U of the circuit layer 121 may be divided into a plurality of portions. For example, the first surface 121U of the circuit layer 121 may include a first portion 121U1-1 corresponding to the second metal layer 121-2, and a second portion 121U-2 corresponding to the third metal layer 121-3. For example, the first surface 121U of the circuit layer 121 may include a first portion 121U1-1 corresponding to a first metal material (e.g., copper) and a second portion 121U-2 corresponding to a second metal material (e.g., tin) different from the first metal material.

For example, the second surface 121S1 of the circuit layer 121 may be divided into a plurality of portions. For example, the second surface 121S1 of the circuit layer 121 may include a first portion 121S1-1 corresponding to the first metal layer 121-1 and the second metal layer 121-2, and a second portion 121S1-2 corresponding to the third metal layer 121-3. For example, the second surface 121S1 of the circuit layer 121 may include a first portion 121S1-1 corresponding to a first metal material (e.g., copper) and a second portion 121S1-2 corresponding to a second metal material (e.g., tin) different from the first metal material.

For example, the third surface 121S2 of the circuit layer 121 may be divided into a plurality of portions. For example, the third surface 121S2 of the circuit layer 121 may include a first portion 121S2-1 corresponding to the first and second metal layers 121-1 and 121-2, and a second portion 121S2-2 corresponding to the third metal layer 121-3. For example, the third surface 121S2 of the circuit layer 121 may include a first portion 121S2-1 corresponding to a first metal material (e.g., copper) and a second portion 121S2-2 corresponding to a second metal material (e.g., tin) different from the first metal material.

As described above, in an embodiment, a surface layer is formed by performing a surface treatment on the surface of the circuit layer 121 using tin. In this case, the surface layer may be partially formed without being entirely formed on the surface of the circuit layer. For example, the circuit layer may include a plurality of valleys and mountains corresponding to the surface roughness. In addition, the surface layer may be formed by partially filling a plurality of valleys of the surface of the circuit layer. In addition, an embodiment may reduce the surface roughness of the circuit layer to correspond to the thickness of the surface layer filling the valleys.

Specifically, referring to FIGS. 6 and 7, it may be confirmed that the third metal layer 121-3 according to the embodiment is formed by filling a portion of the plurality of mountains and valleys on the surface of the circuit layer 121.

That is, FIG. 6 (a) is a view (magnification: 10k) obtained by photographing a surface before the third metal layer 121-3 is formed according to an embodiment, and FIG. 6(b) is a view (magnification: 30k) obtained by photographing the surface of FIG. 6(a) in a state in which the surface of FIG. 6(a) is tilted by 40 degrees. Referring to FIG. 6(a) and FIG. 6(b), it may be confirmed that a certain level of surface roughness (e.g., before the third metal layer 121-3 is formed) is formed on the surface of the circuit layer 121 (e.g., mountains and valleys of a certain depth or height).

That is, FIG. 7(a) is a view (magnification: 10k) obtained by photographing the surface of the circuit layer having the third metal layer 121-3 formed after the surface treatment according to an embodiment, and FIG. 7(b) is a view (magnification: 30k) obtained by photographing the surface of FIG. 7(a) in a state in which the surface of FIG. 7(a) is tilted by 40 degrees. Referring to FIG. 7(a) and FIG. 7(b), it may be confirmed that the surface of the circuit layer 121 after the surface treatment has surface roughness lower (e.g., mountains and valleys of a low depth or a low height) than that of the circuit layer 121 before the surface treatment.

Specifically, in an embodiment, surface roughness of the circuit layer 121 may be reduced by forming the third metal layer 121-3.

For example, the arithmetic average roughness Ra of the surface of the circuit layer 121 of the embodiment may be 0.2 µm or less. For example, the arithmetic average roughness Ra of the surface of the circuit layer 121 of the embodiment may be 0.1 µm or less.

Specifically, the arithmetic average roughness Ra of the surface of the circuit layer 121 of the embodiment may have a range of 0.05 µm to 0.2 µm. Preferably, the arithmetic average roughness Ra of the surface of the circuit layer 121 of the embodiment may have a range of 0.08 µm to 0.18 µm. More preferably, the arithmetic average roughness Ra of the surface of the circuit layer 121 of the embodiment may have a range of 0.09 µm to 0.15 µm.

For example, a ten-point average roughness (Rz) of the surface of the circuit layer 121 of the embodiment may be 1 µm or less. For example, a ten-point average roughness (Rz) of the surface of the circuit layer 121 of the embodiment may be 0.8 µm or less. For example, a ten-point average roughness (Rz) of the surface of the circuit layer 121 of the embodiment may be 0.6 µm or less.

Specifically, the ten-point average roughness Rz of the surface of the circuit layer 121 of the embodiment may have a range of 0.1 µm to 1.0 µm. Preferably, the ten-point average roughness Rz of the surface of the circuit layer 121 of the embodiment may have a range of 0.15 µm to 0.8 µm. More preferably, the ten-point average roughness Rz of the surface of the circuit layer 121 of the embodiment may have a range of 0.15 µm to 0.6 µm.

In this case, if the arithmetic average roughness Ra or the ten-point average roughness Rz of the surface of the circuit layer 121 is less than the above-described range, resistance of the circuit layer may increase. Also, if the arithmetic average roughness Ra or the ten-point average roughness Rz of the surface of the circuit layer 121 is less than the above-described range, adhesion with an additionally stacked insulating layer may not be secured. Also, if the arithmetic average roughness Ra or the ten-point average roughness Rz of the surface of the circuit layer 121 is greater than the above-described range, signal transmission loss may increase due to a skin effect. For example, if the arithmetic average roughness Ra or ten-point average roughness Rz of the surface of the circuit layer 121 is greater than the above-described range, a circuit board suitable for high frequency applications may not be provided.

Meanwhile, results of testing a transmission loss of the circuit layer according to an embodiment are shown in Table 1 below.

**[Table 1]**

| | Transmission loss(dB/in), strip line | | |
|---|---|---|---|
| | 20GHz | 30GHz | 40GHz |
| Embodiment | -1.49 | -1.77 | -2.04 |
| Comparative example | -1.77 | -2.12 | -2.46 |

Referring to Table 1, it was confirmed that the signal transmission loss of the comparative example under a condition of transmitting a signal of 20 GHz was -1.77. In addition, it was confirmed that the embodiment had a signal transmission loss of - 1.49, which was lower than the comparative example. In addition, it was confirmed that the signal transmission loss of the comparative example under the condition of transmitting the signal of 30 GHz was -2.12. In addition, it was confirmed that the embodiment had a signal transmission loss of -1.77, which was lower than the comparative example.

In addition, it was confirmed that the signal transmission loss of the comparative example under the condition of transmitting the signal of 40 GHz was -2.46. In addition, it was confirmed that the embodiment had a signal transmission loss of - 2.04, which was lower than the comparative example.

As described above, in an embodiment, plating is performed on the surface of the circuit layer 121. In addition, in an embodiment, the surface roughness of the circuit layer 121 is lower than that of the comparative example by the third metal layer 121-3. Accordingly, the embodiment can reduce the signal transmission loss of the circuit layer 121 and improve the signal characteristics accordingly. In addition, the embodiment can provide a circuit board suitable for high frequency applications.

Meanwhile, the third metal layer 121-3 according to the first embodiment of FIG. 5 is formed on the surface of the circuit layer 121 with a constant curvature. For example, the third metal layer 121-3 of the first embodiment may have a curved surface convex in an outward direction or a curved surface recessed in an inward direction.

Alternatively, as shown in FIG. 8, the circuit layer 121a of a second embodiment may have a shape different from that of the first embodiment.

For example, the surface of the circuit layer 121a of the second embodiment may include a first surface 121Ua, a second surface 121S1a, and a third surface 121S2a.

The first surface 121Ua of the circuit layer 121a may be divided into a plurality of portions. For example, the first surface 121Ua of the circuit layer 121a may include a first portion 121U1-1 corresponding to the second metal layer 121-2, and a second portion 121U-2a corresponding to the third metal layer 121-3a. For example, the first surface 121Ua of the circuit layer 121a may include a first portion 121U1-1 corresponding to a first metal material (e.g., copper) and a second portion 121U-2a corresponding to a second metal material (e.g., tin) different from the first metal material. In this case, the first portion 121U1-1 of the first surface 121Ua may have a curvature. In addition, the second portion 121U-2a of the first surface 121Ua may be flat. At this time, the fact that the second portion 121U-2a of the first surface 121Ua is flat may mean that a difference between a maximum height and a minimum height of the upper surface of the second portion 121U-2a is 0.05 µm or less, or 0.03 µm or less, or 0.02 µm or less.

In addition, the second surface 121S1a of the circuit layer 121a may include a first portion 121S1-1 corresponding to the first metal layer 121-1 and the second metal layer 121-2, and a second portion 121S1-2a corresponding to the third metal layer 121-3a. For example, the second surface 121S1a of the circuit layer 121a may include a first portion 121S1-1 corresponding to a first metal material (e.g., copper) and a second portion 121S1-2a corresponding to a second metal material (e.g., tin) different from the first metal material. In this case, the first portion 121S1-1 of the second surface 121S1a may have a predetermined curvature, and the second portion 121S1-2a may be flat.

For example, the third surface 121S2a of the circuit layer 121a may be divided into a plurality of portions. For example, the third surface 121S2a of the circuit layer 121a may include a first portion 121S2-1 corresponding to the first and second metal layers 121-1 and 121-2, and a second portion 121S2-2a corresponding to the third metal layer 121-3a. For example, the third surface 121S2a of the circuit layer 121a may include a first portion 121S2-1 corresponding to a first metal material (e.g., copper) and a second portion 121S2-2a corresponding to a second metal material (e.g., tin) different from the first metal material. In this case, the first portion 121S2-1 of the third surface 121S2a may have a curvature, and the second portion 121S2-2a may be flat.

Meanwhile, an embodiment includes a second portion of the circuit layer 121 containing tin as well as a first portion of the surface of the circuit layer 121 containing copper. Accordingly, an embodiment may further improve an adhesive force between the circuit layer 121 and the second insulating layer 112.

FIG. 9 is a view for explaining an adhesive force between a circuit layer and an insulating layer according to the embodiment.

Referring to FIG. 9, the circuit board of an embodiment includes a first insulating layer 111, a circuit layer 121, and a second insulating layer 112.

In this case, the circuit layer 121 is disposed on the first insulating layer 111. In addition, the second insulating layer 112 is disposed on the first insulating layer 111 while covering the circuit layer 121.

In this case, a surface of the circuit layer 121 is divided into a plurality of portions as described above. For example, a surface of the circuit layer 121 includes a first portion including copper corresponding to the first metal layer 121-1 and the second metal layer 121-2, and a second portion including tin corresponding to the third surface 121S2.

Accordingly, a lower surface of the second insulating layer 112 may be divided into a plurality of portions corresponding to the surface of the circuit layer 121.

For example, a lower surface of the second insulating layer 112 includes a first lower surface 112B1 contacting the first metal layer 121-1 and the second metal layer 121-2 of the circuit layer 121. For example, the lower surface of the second insulating layer 112 includes a first surface 112B1 in contact with the first portion 121U-1 of the first surface 121U of the circuit layer 121, the first portion 121S1-1 of the second surface 121S1 and the first portion 121S2-1 of the third surface 121S2.

Also, a lower surface of the second insulating layer 112 includes a second lower surface 112B2 contacting the third metal layer 121-3 of the circuit layer 121. For example, the lower surface of the second insulating layer 112 includes a second lower surface 112B2 in contact with the second portion 121U-2 of the first surface 121U of the circuit layer 121, the second portion 121S1-2 of the second surface 121S1, and the second portion 121S2-2 of the third surface 121S2.

In addition, the lower surface of the second insulating layer 112 includes a third lower surface 112B3 in contact with an upper surface of the first insulating layer 111.

In this case, the second insulating layer in the comparative example includes only the first lower surface and the third lower surface among the lower surfaces of the second insulating layer in the embodiment.

Alternatively, the second insulating layer 112 of an embodiment further includes a second lower surface 112B2 as well as the first and third lower surfaces 112B1 and 112B3. In addition, in an embodiment, since the second insulating layer 112 further includes the second lower surface 112B2, the adhesive force between the second insulating layer 112 and the circuit layer 121 may be improved.

For example, the first portion of the surface of the circuit layer 121 contains copper. In addition, the second portion of the circuit layer 121 contains tin. In this case, an isoelectric point for each oxide of copper and tin is shown in Table 2 below. Here, the isoelectric point may represent a number of hydroxyl groups on the surface of the oxide of each material.

**[Table 2]**

| oxide | IEPS |
|---|---|
| CuO | 9.5 |
| SnO₂ | 4.3 |

The IEPS in Table 1 may be a unit representing a content of the isoelectric point IEP. Referring to Table 1, it may be confirmed that the IEPS of CuO, which is an oxide of copper, is 9.5, and the IEPS of SnO2, which is an oxide of tin, is 4.3.

At this time, a low IEPS means that there are a large number of hydroxyl groups on the surface of the oxide layer.

Here, the circuit layer of the comparative example is composed only of copper oxide having a relatively low hydroxyl group content. Accordingly, there is a limit to increasing the adhesive force between the circuit layer and the insulating layer of the comparative example.

Alternatively, the surface of the circuit layer of the embodiment includes not only an oxide of copper but also an oxide of tin. In addition, the oxide of tin contains a greater amount of hydroxyl groups than the oxide of copper.

In this case, a quantity of the hydroxyl group is related to an adhesive force with the second insulating layer 112. For example, as the quantity of the hydroxyl group increases, the adhesive force with the second insulating layer 112, which is a dielectric layer, may be increased. And, in an embodiment, the second insulating layer 112 includes not only the first lower surface 112B1 but also the second lower surface 112B2. Accordingly, an embodiment may further improve the adhesive force between the circuit layer and the second insulating layer 112 compared to the comparative example.

Meanwhile, in an embodiment, since the third metal layer 121-3 is partially formed on the surface of the circuit layer 121, a depth of an undercut of the circuit layer 121 may be reduced compared to the comparative example.

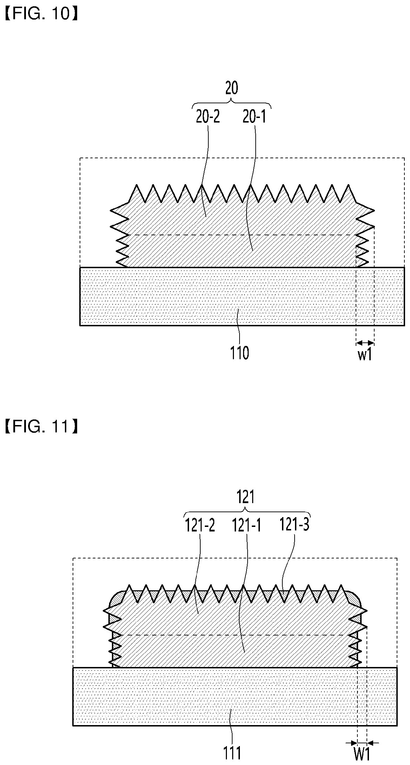

FIG. 10 is a view showing an undercut of a circuit layer according to a comparative example, and FIG. 11 is a view showing an undercut of a circuit layer according to an embodiment.

Referring to FIG. 10, the circuit layer 20 includes a first metal layer 20-1 and a second metal layer 20-2. In a process of etching the first metal layer 20-1, a step may be formed between a side surface of the first metal layer 201 and a side surface of the second metal layer 20-2. The step may be referred to as an undercut formed at a lower side surface of the circuit layer 20. A depth of the undercut may mean a horizontal distance between an outermost side of the side surface of the circuit layer 20 and an innermost side of the circuit layer 20.

In this case, a depth w1 of the undercut in the comparative example is greater than 5 µm. For example, the depth w1 of the undercut in the comparative example is greater than 6 µm. In addition, the undercut may function as a factor that deteriorates electrical reliability and physical reliability of the circuit layer. For example, as the depth of the undercut increases, the electrical reliability and physical reliability of the circuit layer may decrease.

Referring to FIG. 11, the circuit layer 121 of an embodiment includes a first metal layer 121-1, a second metal layer 121-2, and a third metal layer 121-3. In addition, the third metal layer 121-3 may be partially formed on the surfaces of the first metal layer 121-1 and the second metal layer 121-2.

In this case, the third metal layer 121-3 is also disposed on a side surface of the first metal layer 121-1. For example, the third metal layer 121-3 is formed by filling a portion of valleys of the side surface of the first metal layer 121-1. Accordingly, an embodiment may reduce a depth of an undercut of the circuit layer 121 based on a thickness of the third metal layer 121-3.

For example, an embodiment may reduce the depth W1 of the undercut to 4 µm or less. For example, an embodiment may reduce the depth W1 of the undercut to 3 µm or less. Accordingly, an embodiment may reduce the depth of an undercut of the circuit layer 121 as compared with the comparative example, and thus may improve the electrical reliability and physical reliability of the circuit layer 121.

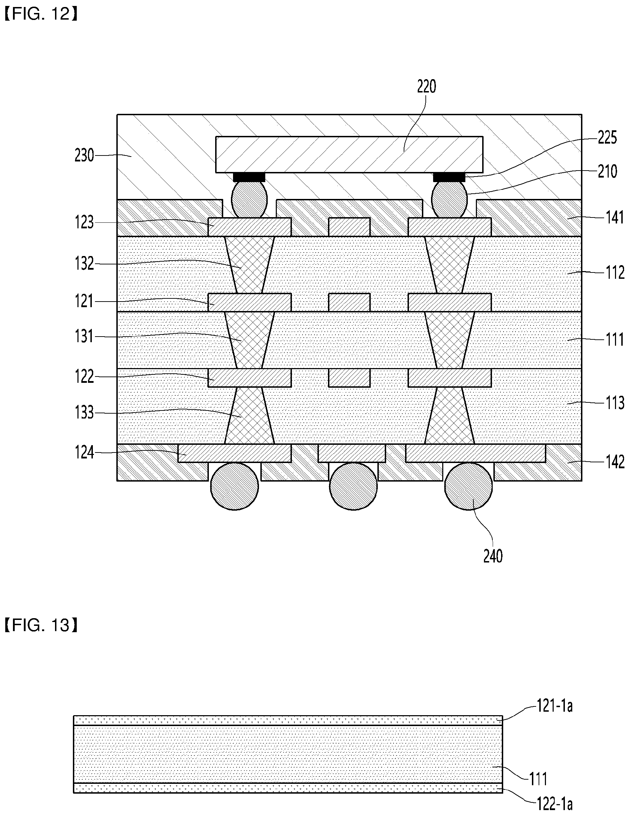

FIG. 12 is a view illustrating a semiconductor package according to an embodiment.

Referring to FIG. 12, the semiconductor package according to an embodiment includes the circuit board described with reference to the previous drawings.

The circuit board includes a first protective layer 141 and a second protective layer 142. In addition, each of the first protective layer 141 and the second protective layer 142 includes an opening.

Meanwhile, the semiconductor package includes a first connection part 210 disposed in the opening of the first protective layer 141. For example, the first connection part 210 may be disposed on the third circuit layer 123 vertically overlapping the opening of the first protective layer 141.

The first connection part 210 may include a spherical shape. For example, a cross section of the first connection part 210 may have a circular shape or a semicircular shape. For example, a cross section of the first connection part 210 may have a partially or entirely rounded shape. For example, a cross-sectional shape of the first connection part 210 may be a flat surface on one side and a curved surface on the other side. The first connection part 210 may be a solder ball, but is not limited thereto.

A device 220 may be disposed on the first connection part 210. The device 220 may be a processor chip. For example, the device 220 may be any one of a central processor (e.g., CPU), a graphic processor (e.g., GPU), a digital signal processor, an encryption processor, a microprocessor, and a microcontroller. However, embodiments are not limited thereto, and the device 220 may be various types of passive devices or active devices such as a driver IC, a capacitor, and an inductor other than the processor chip.

A terminal 225 is formed at a lower surface of the device 220. In addition, the terminal 225 of the device 220 is connected to the first connection part 210. Accordingly, the device 220 may be electrically connected to the third circuit layer 123.

In this case, although it is illustrated that one device is mounted on a circuit board in the drawing, the embodiment is not limited thereto. For example, the semiconductor package according to an embodiment may include a first device and a second device disposed to be spaced apart from each other in a horizontal direction on one circuit board.

For example, a first device and a second device may be different types of application processors AP.

In this case, the first device and the second device may be spaced apart from each other by a predetermined separation distance in a horizontal direction on the circuit board. For example, a separation distance of the first device and the second device in a horizontal direction may be 150 µm or less. For example, a separation distance of the first device and the second device in a horizontal direction may be 120 µm or less. For example, a separation distance of the first device and the second device in a horizontal direction may be 100 µm or less.

Preferably, the separation distance of the first device and the second device in the horizontal direction may satisfy a range of 60 µm to 150 µm. More preferably, the separation distance of the first device and the second device in the horizontal direction may satisfy a range of 70 µm to 120 µm. More preferably, the separation distance of the first device and the second device in the horizontal direction may satisfy a range of 80 µm to 110 µm.

In this case, if the separation distance of the first device and the second device in the horizontal direction is less than 60 µm, a problem may occur in the operational reliability of the first device or the second device due to mutual interference between the first device and the second device. In addition, if the separation width of the first device and the second device in the horizontal direction is greater than 150 µm, a signal transmission distance between the first device and the second device may increase, and accordingly, a signal transmission loss may increase.

Meanwhile, the semiconductor package may include a molding layer 230. The molding layer 230 may be disposed on the circuit board to mold the device 220. The molding layer 230 may serve to protect the device 220. For example, the molding layer 230 may be an epoxy mold compound (EMC), but is not limited thereto.

Meanwhile, the molding layer 230 may have a low dielectric constant. Accordingly, the molding layer 230 may increase heat dissipation characteristics. To this end, the dielectric constant (Dk) of the molding layer 230 may be in a range of 0.2 to 10. Preferably, the dielectric constant of the molding layer 230 may be in a range of 0.5 to 5. More preferably, the dielectric constant of the molding layer 230 may be in a range of 0.8 to 5. Accordingly, in the embodiment, the molding layer 230 may have a low dielectric constant. Accordingly, the embodiment may increase the heat dissipation characteristics for heat generated by the device 220.

Meanwhile, the semiconductor package further includes a second connection part 240. The second connection part 240 may be disposed at a lowermost side of the circuit board. Preferably, the second protective layer 142 includes an opening. In addition, the second connection part 240 may be disposed in the opening of the second protective layer 142. Preferably, at least a portion of a lower surface of the fourth circuit layer 124 overlaps an opening of the second protective layer 142 in a thickness direction. In addition, the second connection part 240 may be disposed on a lower surface of the fourth circuit layer 124 overlapping an opening of the second protective layer 142 in a thickness direction. The second connection part 240 may be for connecting the semiconductor package to an external substrate (e.g., a main board of an electronic device).

Hereinafter, a method of manufacturing a circuit board according to an embodiment will be described.

FIGS. 13 to 23 are views for explaining a method for manufacturing a circuit board according to an embodiment in order of process.

Referring to FIG. 13, an embodiment prepares a base material that is a basis for manufacturing a circuit board. For example, the base material may have a structure in which an insulating layer and a copper layer or copper foil are attached on the insulating layer.

Specifically, the base material of an embodiment may include a first insulating layer 111, a first-first metal layer 121a of the first circuit layer 121 disposed on the upper surface of the first insulating layer 111, and a first-first metal layer 122-1a of the second circuit layer 122 disposed on the lower surface of the first insulating layer 111.

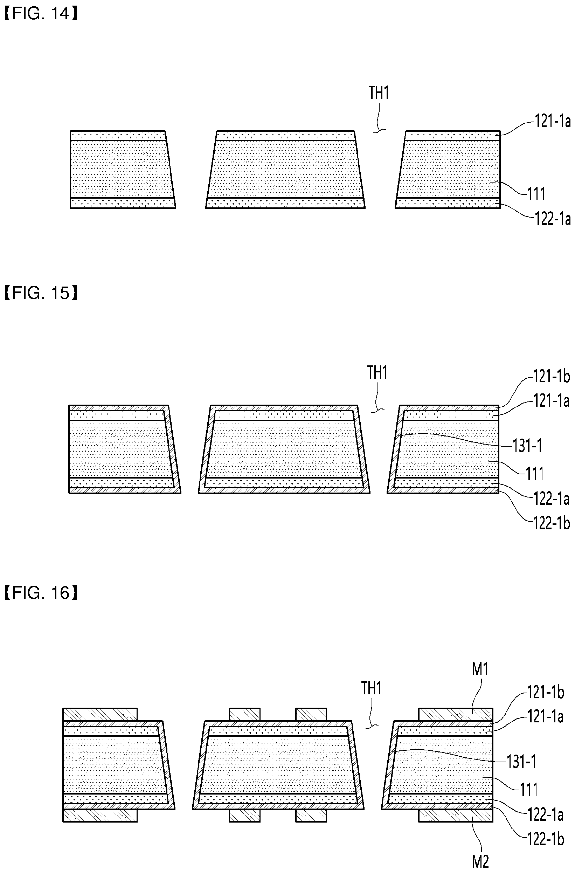

Next, referring to FIG. 14, an embodiment may perform a process of forming through-holes TH1 penetrating upper and lower surfaces of the prepared base material. In this case, FIG. 14 may illustrate a method of manufacturing a circuit board by an MSAP process. Alternatively, when a circuit board is manufactured by an SAP process, a process of removing the first-first metal layer 121-1a of the first circuit layer 121 and the first-first metal layer 122-1a of the second circuit layer 122 may be performed.

The through hole TH1 may penetrate from an upper surface of the first-first metal layer 121-1a of the first circuit layer 121 to a lower surface of the first-first metal layer 122-1a of the second circuit layer 122.

Next, referring to FIG. 15, in the embodiment, chemical copper plating may be performed to form a chemical copper plating layer.

In this case, the chemical copper plating layer is formed as substantially one layer, but may be classified as follows depending on a position.

That is, the chemical copper plating layer may include a first-second metal layer 121-1b of the first circuit layer 121 formed on the upper surface of the first-first metal layer 121-1a of the first circuit layer 121, a first-second metal layer 122-1b of the second circuit layer 122 formed on the lower surface of the first-first metal layer 122-1a of the second circuit layer 122, and a first metal layer 131-1 of the first through electrode 131 formed on an inner wall of the through hole TH1.

Next, as shown in FIG. 16, the embodiment may proceed with a process of forming a mask.

For example, the embodiment may proceed with a process of forming a first mask M1 on the upper surface of the first-second metal layer 121-1b of the first circuit layer 121. In this case, the first mask M1 may include an open portion. For example, the first mask M1 may include an open portion overlapping an arrangement region of the second metal layer 121-2 of the first circuit layer 121 and an arrangement region of the first through electrode 131 in a thickness direction.

In addition, the embodiment may proceed with a process of forming a second mask M2 on a lower surface of the first-second metal layer 122-1b of the second circuit layer 122. In this case, the second mask M2 may include an open portion. For example, the second mask M2 may include an open portion overlapping an arrangement region of the second metal layer 122-2 of the second circuit layer 122 and an arrangement region of the first through electrode 131 in a thickness direction.

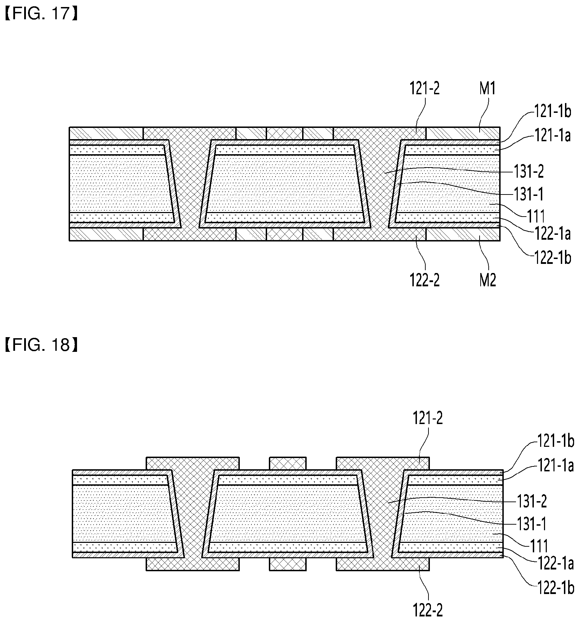

Next, as shown in FIG. 17, the embodiment may form an electroplating layer that fills the open portion of the first mask M1, the open portion of the second mask M2, and the through hole TH1.

In this case, the electroplating layer may mean one layer substantially connected to each other, but may be divided into a plurality of portions as follows depending on a position.

The electroplating layer may include a second metal layer 121-2 of the first circuit layer 121 disposed in the open portion of the first mask M1. Also, the electroplating layer may include a second metal layer 122-2 of the second circuit layer 122 disposed in the open portion of the second mask M2. Also, the electroplating layer may include a second metal layer 131-2 of the first through electrode 131 disposed in the through hole TH1.

Next, as shown in FIG. 18, an embodiment may perform a process of removing the first mask M1 and the second mask M2.

In this case, as the first mask M1 is removed, a non-arrangement region of the second metal layer 121-2 of the first circuit layer 121 among the upper surfaces of the first-second metal layer 121-1b of the first circuit layer 121 may be exposed to an outside.

In addition, as the second mask M2 is removed, a non-arranged region of the second metal layer 122-2 of the second circuit layer 122 among the lower surfaces of the first-second metal layer 122-1b of the second circuit layer 122 may be exposed to an outside.

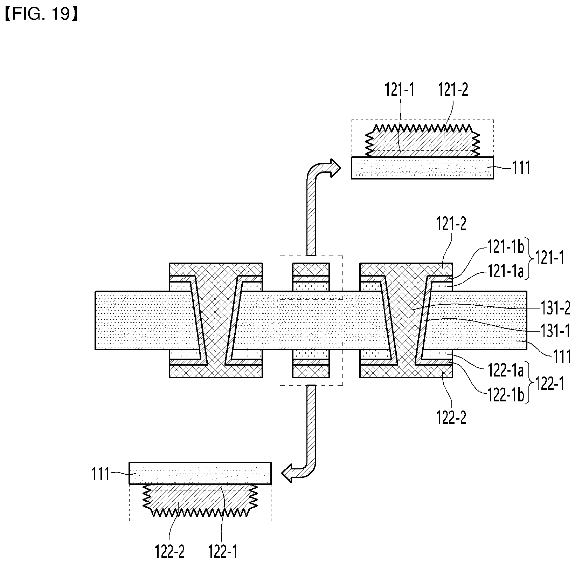

Next, referring to FIG. 19, the embodiment may proceed with an etching process of removing a region of the first metal layer (the first-first metal layer and the first-second metal layer) of the first circuit layer 121 that does not overlap in the thickness direction.

In addition, the embodiment may perform an etching process of removing a region of the first metal layer (first-first metal layer and first-second metal layer) of the second circuit layer 122 that does not overlap in the thickness direction.

In this case, each of the first metal layers of the first circuit layer 121 and the second circuit layer 122 has a thickness of about 3 µm. Accordingly, the etching process may mean a process of removing about 3 µm in a thickness direction.

Here, in the etching process of the first metal layer, surfaces of the first circuit layer 121 and the second circuit layer 122 may have an arithmetic average roughness Ra and a ten-point average roughness Rz as described above.

For example, the first metal layer 121-1 and the second metal layer 121-2 of the first circuit layer 121 may be pretreated in the etching process. In addition, the surface roughness of the arithmetic average roughness Ra and the ten-point average roughness Rz may be applied to the first metal layer 121-1 and the second metal layer 121-2 of the first circuit layer 121 by the pretreatment.

Correspondingly, the first metal layer 122-1 and the second metal layer 122-2 of the second circuit layer 122 may be pretreated in the etching process. In addition, the first metal layer 122-1 and the second metal layer 122-2 of the second circuit layer 122 may be applied to the surface roughness of the arithmetic average roughness Ra and the ten-point average roughness Rz as described above by the pretreatment.

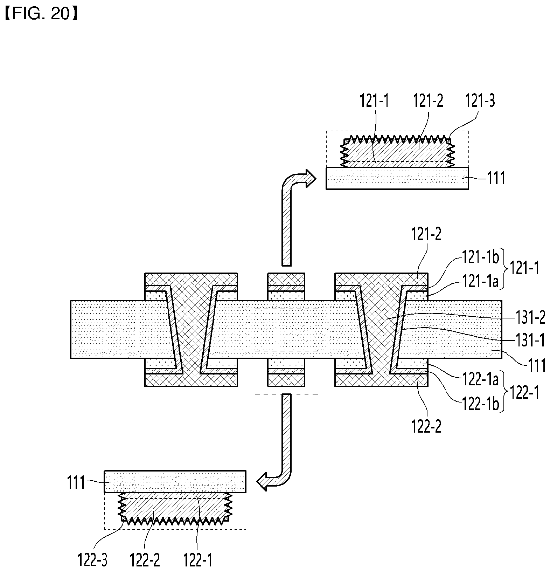

Next, as shown in FIG. 20, an embodiment may perform a process of forming a surface layer on the surface of the first circuit layer 121 and the surface of the second circuit layer 122. In this case, the surface layer may be partially formed on the surface of the first circuit layer 121 and the surface of the second circuit layer 122, respectively.

For example, the surface layer includes a first surface layer 121-3 or a third metal layer 121-3 of the first circuit layer 121 disposed on the surface of the first circuit layer 121. In addition, the third metal layer 121-3 of the first circuit layer 121 may be formed on an upper surface and a side surface of the first circuit layer 121. In this case, the surface of the first circuit layer 121 includes a plurality of mountains and valleys corresponding to the surface roughness applied in the pretreatment process. In addition, the third metal layer 121-3 may be formed to fill a portion of valleys of the surface of the first circuit layer 121.

Correspondingly, the surface layer includes a second surface layer 122-3 or a third metal layer 122-3 of the second circuit layer 122 disposed on the surface of the second circuit layer 122. Furthermore, the third metal layer 122-3 of the second circuit layer 122 may be formed on the lower and side surfaces of the second circuit layer 122. In this case, the surface of the second circuit layer 122 includes a plurality of mountains and valleys corresponding to the surface roughness applied in the pretreatment process. Furthermore, the third metal layer 122-3 may be formed to fill a portion of valleys of the surface of the second circuit layer 122. Accordingly, an embodiment may reduce the surface roughness of the surface of the first circuit layer 121 compared to the comparative example, by allowing the first circuit layer 121 to include the third metal layer 121-3. Furthermore, the surface roughness of the second circuit layer 122 may be reduced compared to the comparative example by including the third metal layer 122-3 of the second circuit layer 122.

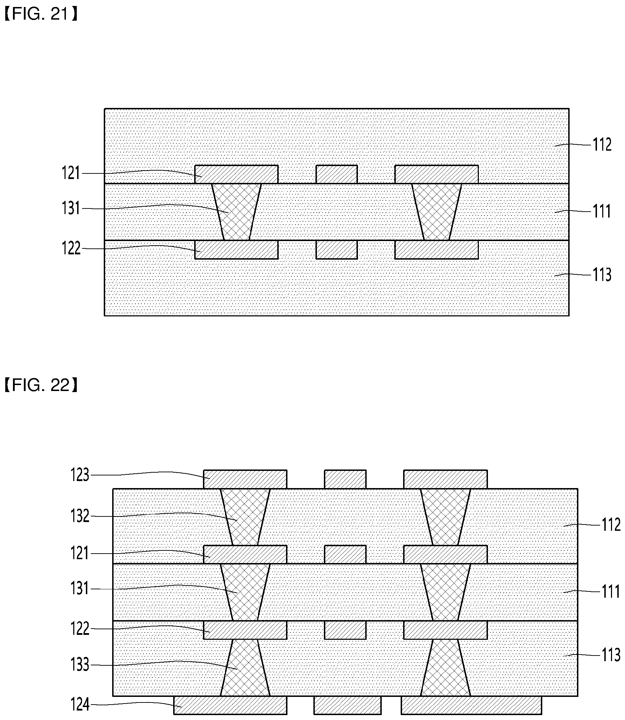

Next, as shown in FIG. 21, the embodiment may proceed with a process of stacking the second insulating layer 112 on the upper surface of the first insulating layer 111. In addition, the embodiment may proceed with a process of stacking the third insulating layer 113 on the lower surface of the first insulating layer 111.

In this case, the second insulating layer 112 may include a first lower surface in contact with the first and second metal layers 121-1 and 121-2 of the first circuit layer 121, a second lower surface in contact with the third metal layer 121-3, and a third lower surface in contact with the upper surface of the first insulating layer 111.

In addition, the third insulating layer 113 may include a first upper surface in contact with the first and second metal layers 122-1 and 122-2 of the second circuit layer 122, a second upper surface in contact with the third metal layer 122-3, and a third upper surface in contact with the lower surface of the first insulating layer 111.

Next, referring to FIG. 22, the embodiment may perform a process of forming a second through electrode 132 passing through the second insulating layer 112 and the third circuit layer 123 disposed on an upper surface of the second insulating layer 112. In this case, the process of forming the third circuit layer 123 may be the same as the process of forming the first circuit layer 121. Accordingly, the surface roughness of the third circuit layer 123 may correspond to the surface roughness of the first circuit layer 121. For example, the third circuit layer 123 may include first to third metal layers corresponding to the first circuit layer 121. To this end, in a process of stacking the second insulating layer 112, a copper foil layer (not shown) or a copper foil (not shown) may be disposed on the upper surface of the second insulating layer 112.

In addition, the embodiment may perform a process of forming a third through electrode 133 penetrating the third insulating layer 113 and a fourth circuit layer 124 disposed on a lower surface of the third insulating layer 1131. In this case, a process of forming the fourth circuit layer 124 may be the same as a process of forming the second circuit layer 122. Accordingly, a surface roughness of the fourth circuit layer 124 may correspond to a surface roughness of the second circuit layer 122. For example, the fourth circuit layer 124 may include first to third metal layers corresponding to the second circuit layer 122. To this end, in a process of stacking the third insulating layer 113, a copper foil layer (not shown) or a copper foil (not shown) may be disposed on a lower surface of the third insulating layer 112.

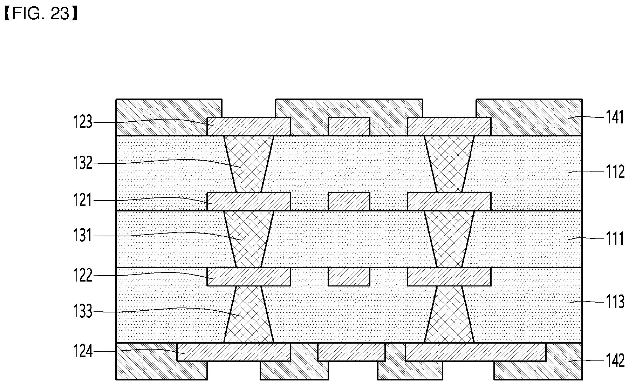

Next, as shown in FIG. 23, the embodiment may perform a process of forming a first protective layer 141 on an upper surface of the second insulating layer 112. In addition, the embodiment may perform a process of forming a second protective layer 142 on a lower surface of the third insulating layer 113. In addition, the embodiment may perform a process of forming a first opening of the first protective layer 141 overlapping at least a portion of an upper surface of the third circuit layer 123 in a thickness direction. In addition, the embodiment may perform a process of forming a second opening of the second protective layer 142 overlapping at least a portion of a lower surface of the fourth circuit layer 124 in a thickness direction.

A circuit board according to an embodiment includes a circuit layer. The circuit layer includes a first metal layer corresponding to a seed layer and a second metal layer disposed on the first metal layer. In this case, a surface of the circuit layer can be provided with a certain level of surface roughness in a process of etching process the first metal layer. In addition, the surface roughness may act as a factor of increasing signal transmission loss. Accordingly, it may be difficult to apply to high frequency applications.

Accordingly, the circuit layer of the embodiment includes a third metal layer. The third metal layer is selectively disposed on a surface of the first metal layer and a surface of the second metal layer. For example, a surface of the circuit layer includes a first surface corresponding to an upper surface of the second metal layer. In addition, the third metal layer is partially disposed on the first surface. Specifically, the first surface includes a plurality of valleys and mountains corresponding to the surface roughness. In addition, the third metal layer is formed to fill a portion of the valleys on the first surface by controlling crystal grains of metal ions in a plating solution. Accordingly, the embodiment can reduce the surface roughness of the first surface based on a thickness of the third metal layer.

Correspondingly, the surface of the circuit layer includes a second surface corresponding to a first side surface of the first metal layer and a first side surface of the second metal layer. In addition, the surface of the circuit layer includes a third surface corresponding to a second side surface of the first metal layer and a second side surface of the second metal layer. In addition, the third metal layer is disposed to fill not only the first surface, but also a portion of the valley of the second surface and a portion of the valley of the third surface. Accordingly, an embodiment can reduce the surface roughness of the second surface and the third surface of the circuit layer.

Accordingly, the embodiment can reduce the signal transmission loss of the circuit layer compared to a comparative example. Accordingly, the embodiment can improve signal characteristics of the circuit board. Furthermore, the embodiment can provide a circuit board suitable for high frequency applications.

Meanwhile, the embodiment allows the third metal layer to be disposed so as to fill only a portion of the valleys of the first to third surfaces. Accordingly, embodiment may reduce the surface roughness of the circuit layer without affecting a thickness and a line width of the circuit layer including the first metal layer and the second metal layer. Accordingly, the embodiment may further improve electrical reliability and physical reliability of the circuit board.

Meanwhile, in an embodiment, an additional insulating layer is stacked on the circuit layer. In this case, the additional insulating layer additionally contacts the third metal layer as well as the first and second metal layers of the circuit layer. In this case, the first and second metal layers may include copper, and the third metal layers may include tin. In this case, the tin includes more hydroxyl groups than the copper. In addition, the additional insulating layer may have a higher adhesive force to the third metal layer than to the first and second metal layers. At this time, the additional insulating layer in the comparative example contacts only the first and second metal layers of the circuit layer. Accordingly, in the comparative example, there is a limit to increasing the adhesive force between the circuit layer and the additional insulating layer. Unlike this, the additional insulating layer of the embodiment additionally contacts the third metal layer as well as the first and second metal layers of the circuit layer. Accordingly, the embodiment may improve the adhesive force between the circuit layer and the additional insulating layer compared to the comparative example. Accordingly, the embodiment may further improve product reliability of the circuit board.

Meanwhile, an undercut is formed at a lower portion of a side surface of the circuit layer of the comparative example. In addition, the undercut acts as a factor for deteriorating the reliability of the circuit layer. In this case, the embodiment can reduce a depth of the undercut by a thickness of the third metal layer compared to the comparative example. Accordingly, the embodiment can further improve the product reliability of the circuit board.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

## Claims

1. A circuit board comprising:
a first insulating layer; and
a circuit layer disposed on the first insulating layer,
wherein the circuit layer includes:
a first layer disposed on the first insulating layer, and
a second layer partially disposed on a surface of the first layer,
wherein a profile of the surface of the first layer is different from a profile of a surface of the second layer.

2. The circuit board of claim 1, wherein the first layer of the circuit layer includes:
a first metal layer disposed on an upper surface of the first insulating layer, and
a second metal layer disposed on an upper surface of the first metal layer,
wherein the second layer of the circuit layer includes a third metal layer disposed on an upper surface of the second metal layer, and
wherein a profile of the upper surface of the second metal layer is different from a profile of an upper surface of the third metal layer.

3. The circuit board of claim 2, wherein the upper surface of the second metal layer includes a plurality of mountains and a plurality of valleys, and
wherein the third metal layer is formed on the upper surface of the second metal layer to fill at least a portion of the plurality of valleys.

4. The circuit board of claim 2, wherein the third metal layer is disposed on a side surface of the first metal layer and a side surface of the second metal layer, and
wherein each profile of the side surface of the first metal layer and the side surface of the second metal layer is different from a profile of a side surface of the third metal layer.

5. The circuit board of claim 4, wherein each of the side surface of the first metal layer and the side surface of the second metal layer includes a plurality of mountains and a plurality of valleys, and
wherein the third metal layer fills at least a portion of the plurality of valleys of each of the side surfaces of the first and second metal layers.

6. The circuit board of claim 2 or 3, wherein an upper surface of the circuit layer includes:
a first portion corresponding to the upper surface of the second metal layer, and
a second portion corresponding to the upper surface of the third metal layer.

7. The circuit board of claim 6, wherein an arithmetic average roughness Ra of the upper surface of the circuit layer has a range of 0.05 µm to 0.2 µm, and
wherein a ten-point average roughness Rz of the upper surface of the circuit layer is in a range of 0.1 µm to 1.0 µm.

8. The circuit board of claim 4 or 5, wherein a side surface of the circuit layer includes:
a first portion corresponding to the side surfaces of the first and second metal layers, and
a second portion corresponding to a side surface of the third metal layer.

9. The circuit board of claim 8, wherein an arithmetic average roughness Ra of the side surface of the circuit layer has a range of 0.05 µm to 0.2 µm, and
wherein a ten-point average roughness Rz of the side surface of the circuit layer is in a range of 0.1 µm to 1.0 µm.

10. The circuit board of claim 1, further comprising:
a second insulating layer disposed on the first insulating layer to cover the circuit layer,
wherein a lower surface of the second insulating layer includes:
a first lower surface in contact with the first layer of the circuit layer,
a second lower surface in contact with the second layer of the circuit layer, and
a third lower surface in contact with the first insulating layer.
